# EUROPEAN PATENT APPLICATION

(11) **EP 2 226 850 A1**
(43) Date of publication of application: **08.09.2010**
(21) Application number: 09003276.4
(22) Date of filing: 06.03.2009
(51) Int. Cl.: H01L 31/042, H01L 31/05, H01L 27/142, G08B 13/14

(54) **Solar module having integrated electronic devices**

(71) Applicant: SAPHIRE ApS, 1820 Frederiksberg (DK)
(72) Inventor: Safir, Yakov, 1820 Frederiksberg (DK)
(74) Representative: Nielsen, Henrik Sten

(57) **Abstract**

A solar module comprising a shallow enclosure comprising a transparent front plate. The enclosure comprising a plurality of solar cell assemblies and a plurality of bypass diode assemblies. The plurality of bypass diode assemblies being identical to the plurality of solar cell assemblies. Each of the solar cell assemblies comprising one or more solar cell elements of semiconductor based material. Each of the bypass diode assemblies comprising a set of parallel- and/or series-connected individual bypass diodes. The bypass diodes being separated in relation to each other for allowing residual heat generated by the individual bypass diodes to dissipate. The individual bypass diodes being accommodated juxtaposed with the one or more solar cell elements and electrically connected in parallel in relation to the one or more solar cell elements for allowing individual bypassing of each of the solar cell assemblies of the plurality of solar cell assemblies.

## Description

The present invention relates to a solar module having integrated electronic devices and a method of manufacturing a solar module having integrated electronic devices.

Solar cells are well known in the art of energy production for producing electrical energy in an efficient and environmentally friendly way. A solar cell relies on the photovoltaic effect for generating electrical energy from visual radiation, which primarily, but not necessarily constitutes solar light. A typical solar cell consists of a thin silicon (Si) wafer (solar wafer), having a single large p-n junction applied on the front surface, which faces the light. Each of the two surfaces (front and back) of the solar cell is provided with a metal contact, constituting a plus and a minus pole for providing a direct current (DC) through the solar wafer. The photons impinging on the p-n junction will excite charge carriers, which will initiate a current towards their respective poles. Solar cells may be manufactured in varying sizes and geometries.

The DC output current may be used directly for powering a facility or charging a rechargeable battery, or alternatively a rectifier may be employed to convert the DC current to an AC current, which may be delivered to a transmission grid. The above type of solar cell yields a maximum voltage of between 0.3V-0.7V and typically 0.5V. The voltage is weakly dependent on the amount of radiation received by the solar cell. The above applications typically need to be provided with a higher voltage than the voltage delivered by a single cell. Therefore, to be able to achieve higher voltages, a plurality of solar cells has to be connected in series to form a solar module. Due to the very low voltage provided by each individual solar cell, the solar modules may be manufactured including a large amount of solar cells. For example, in a typical commercial solar module for a nominal voltage of 60V, 144 solar cells may be connected in series. Typically a plurality of modules are further connected into a solar array and installed in places subjected to high solar radiation intensity.

Since the solar wafer is typically very brittle and may rupture when subjected to weak to moderate shocks, the solar wafer must be encapsulated within an enclosure for protection. Since solar wafers are mostly located outdoors and on exposed locations such as on roofs etc., the enclosure must be made substantially rigid. The enclosure is typically made by providing a transparent front plate and a non-transparent back plate of either glass or a polymeric material. The solar wafer is encapsulated between the front layer and the back layer to form a laminate structure. The polymeric layers give the solar cell additional rigidity. The thickness of the enclosure should be as thin as possible so as not to subject the support structure, such as the roof, to high forces and to save material.

Since a large number of solar cells are typically connected in series within the solar module, the solar module is very sensitive to reverse biasing of a single solar cell. A reverse biasing of a single solar cell may cause the solar cell to consume power instead of producing power. A reverse biasing may be caused by internal failure such as a permanent defect in the solar cell, or alternatively an external effect such as shading of the solar cell. The shading may be temporary, caused by e.g. a bird or a piece of debris. In such cases the solar cell will resume power production when the shading is removed. Bypass diodes are known in the art for providing remedy to the above problem. By providing a diode in anti-parallel configuration in relation to one or more solar cells, the solar cell(s) may be bypassed or bridged when reversed biased. Under normal power generating conditions, the solar cell is in a positive biased state conducting and producing current, and the bypass diode is in a negatively biased state, i.e. non-conducting. When the solar cell is negatively biased, the bypass diode, being in anti-parallel configuration, will be positively biased and thereby conducting. Typically, the bypass diodes are located in a junction box outside the solar module, e.g. fixed to the back of the solar module. In order to make a compact and cost- effective solar module it would be desirable to avoid the junction box and to integrate the bypass diodes into the enclosure of the solar module. Special low profile diodes are available for avoiding bulges in the enclosure and being able to retain the shallow profile of the enclosure as described above. Another reason for avoiding junction boxes is the increased need for non-standard modules, i.e. curved modules, glass/glass modules or BIPV (building integrated photovoltaic), where standard junction boxes cannot be accommodated due to architectural requirements.

It is well known in the art that bypass diodes may be integrated into the solar module. One example of a solar module having integrated bypass diodes may be found in international patent application no. PCT/US2005/011949 (publication no. WO 2005/101511). In WO 2005/101511, a conductive board including bypass diodes is positioned near the edge inside the solar module for bypassing a set of solar cells located inside the module. Another example may be found in US 5,616,185, which describes a solar cell assembly, having a bypass diode integrated into the semiconductor wafer. The drawback of integrating the bypass diodes into the semiconductor wafer is that hotspots may occur due to overheating of a single diode. Such hotspots may cause the solar module to fail. Overheating of the bypass diodes may in some cases result in the solar module catching fire, which would pose a significant security risk, especially when the solar module is located in populated areas, such as on rooftops etc. Cooling means are, therefore, typically necessary for avoiding overheating and hotspots. Such cooling means add to the overall thickness of the solar module. Additionally, if using a bifacial solar cell according to US 5,665,175, the backside of the solar wafer is occupied by an active area and, thus, not accessible for accommodating electronic devices. It is, therefore, an object according to the present invention to provide technologies for avoiding hotspots by providing distributed bypass diodes.

It may further be desired to include other electronic components in the solar module. Such components may range from single discrete components such as diodes and resistors to intelligent IC components such as control circuitry, battery units and the like. It may be particularly advantageous to include all such components within the solar module to avoid using junction boxes altogether. Solar modules may, thus, be configured to store electrical energy during the daytime and provide energy at nighttime. It is, therefore, a further object according to the present invention to provide technologies for providing visual light effects at nighttime.

The constantly increasing demand for solar modules has resulted in a shortage of solar grade silicon, i.e. high quality silicon having suitable purity for solar applications. It has, therefore, been contemplated to use metallurgical grade silicon, having a lower purity than solar grade silicon in solar modules. Metallurgical grade silicon is widely available at a significantly lower price than solar grade silicon. However, due to the increased amount of impurities in the silicon, the risk of failure in the solar cell is increased. In practice, when using metallurgical grade silicon, there will be a certain percentage of cell failure. When using metallurgical grade silicon, there is, therefore, an increased need for protecting the functional solar cells by providing bypass diodes. There is, thus, a need for accommodating further bypass diodes within the enclosure and, consequently, it is a further object of the present invention to provide a solar module having an increased amount of bypass diodes for being able to use metallurgical grade silicon instead of solar grade silicon.

Another effect of the decreased availability of solar grade silicon and the increasing demand for solar modules has been a dramatic increase in solar module theft. Due to the relative compactness and high price of solar modules, it has become very attractive for thieves to steal the installed solar modules. Solar module theft typically occurs when the site of the solar modules, typically a building, is left without observation or guarding, such as at nighttime. The previously mentioned document, publication no. W02005/101511, discloses a solar module having an electronic anti-theft device, which causes the solar module to deactivate and interrupt power generation when removed from its installation site. However, such designs do not actively prevent the thief from removing the solar module, i.e. the thief may still steal and transport the solar module to a "safe" location and thereafter attempt to remove the electronic anti-theft device. It is, therefore, a further object according to the present invention to provide technologies deterring any unauthorised removal of the solar modules.

The above need and object together with numerous other needs and objects, which will be evident from the below detailed description of a preferred embodiment of the module according to the present invention, are according to a first aspect of the present invention obtained by a solar module, comprising a shallow enclosure, comprising a back plate and a corresponding front plate, the front plate being transparent to solar light, the enclosure further comprising a plurality of solar cell assemblies and a plurality of bypass diode assemblies, all being accommodated between the front and back plates, the plurality of bypass diode assemblies being identical to the plurality of solar cell assemblies and each specific bypass diode assembly having a corresponding solar cell assembly, each of the solar cell assemblies comprising:
one or more solar cell elements of semiconductor-based material exposed to solar light at the front plate, and
each of the bypass diode assemblies comprising:
a set of parallel- and/or series-connected individual bypass diodes, being separated in relation to each other for allowing residual heat generated by the individual bypass diodes to dissipate, the individual bypass diodes being accommodated juxtaposed with one or more solar cell elements and electrically connected in parallel in relation to one or more solar cell elements for allowing individual bypassing of each of the solar cell assemblies of the plurality of solar cell assemblies.

For allowing a large active surface to receive solar light and still maintain a low profile, the enclosure should be shallow. The enclosure comprises a front plate and a back plate and the solar cell assemblies are accommodated between the front and back plates, forming a laminate structure. The front plate and the back plate serve as protection for the fragile solar cell assemblies. The front plate should be transparent to light so that the radiate energy in the light may reach the solar cell assemblies. The solar cell assembly comprises one or more solar cell elements of semiconductor material. The solar cell elements should be positioned so that the active area, i.e. the p-n junction, is facing the front plate so that the active area may be exposed to solar light when the solar module is in use. Having a set of several bypass diodes being parallel- and/or series-connected, instead of a few large bypass diodes, will allow each individual bypass diode to be smaller, thus, the diodes may be accommodated within the laminate structure in exactly the same way as the solar cell assemblies without any bulging of the laminate structure. Large bypass diodes will cause the laminated structure to bulge and increase the risk of accidental de-lamination of the laminate structure, especially when the bypass diodes are hot during use.

When the solar cell is shaded and assuming the negatively biased state, it will start consuming power, which will be dissipated for the most part in the form of thermal energy, i.e. heat. The thermal energy generated may cause a local hotspot, which may damage the solar module. By including a bypass diode assembly, the current may flow through the bypass diode assembly instead of through the solar cell assembly in case of reverse biasing of the solar cell assembly. The current, which flows through the bypass diode assembly, will still cause some heat due to the power consumed in the bypass diode. The bypass diode assembly should, therefore, comprise a set of bypass diodes for distributing the thermal energy and avoiding a local hotspot where the diode is located. Having a set of parallel connected bypass diodes will also provide redundancy in case of a failure of one of the bypass diodes in addition to allowing the heat generated in the bypass diode assembly to be distributed over several individual bypass diodes. The bypass diodes should be separated from each other for distributing the thermal energy and allowing thermal energy to dissipate through the enclosure without causing any damage due to elevated temperatures.

When using metallurgical grade silicon, the increased number of impurities and crystal defects in an individual solar cell element or in the solar cell assembly may cause the solar cell assembly to malfunction. Such malfunction may cause the solar cell assembly to consume energy and subjecting the affected solar cell area to overheating. In particular, the solar cell assembly may permanently assume a reverse biased state similar to a shaded cell. In such cases permanent bypassing of the solar cell assembly will minimise the negative consequences of a malfunction caused by the use of metallurgical grade silicon.

The bypass diode assembly should be juxtaposed with the solar cell elements, i.e. in the spacing between the solar cell elements. The bypass diode may, thus, be easily connected to the solar cell for allowing individual bypassing of each solar cell assembly. The bypass diodes may preferably be applied automatically in connection with the automatic soldering of the current path of the solar cell assembly. The automatic soldering or welding of the current path which interconnects the solar cell element in the solar cell assembly is made by a standard stringer machine well known in the art. The stringer machine may as well do the layout of the solar cell assembly as a string of solar cell elements, e.g. to form a string or matrix, and the layout of the bypass diode assembly. The stringer machine may handle bypass diodes and other components the same way as it handles solar cell elements. The stringer machine may at the same time solder or weld the interconnections between the individual solar cell elements and between the solar cell elements and the bypass diodes and other components and thus the inclusion of bypass diodes between the front and back plates will not result in any reduction in production capacity or need for extra equipment. The bypass diodes will thereby be encapsulated in the same level as the solar cell elements between the front and back plates and protected from moisture and corrosion.

By allowing individual bypassing of each solar cell assembly, the consequences of the loss of a single solar cell assembly will be minimised since only the negatively biased solar cell assemblies will be bypassed. This feature is of special importance if the solar cell assembly is positioned in a location subjected to high levels of debris, or alternatively when using metallurgical grade silicon where a high rate of solar cell failure may be expected.

The solar cell assemblies within the solar module as well as the solar cell element within the solar cell assembly are typically series-connected for achieving a higher voltage than the voltage generated by a single solar cell. Thus, the solar cells within the solar module typically operate at different voltages and, thus, there should not be any galvanic connection between the solar cell assemblies within the solar module, since any galvanic connection between the solar cells may cause a short-circuit. Consequently, a small gap must be provided between the individual solar cell assemblies within the solar module. The gap may preferably be used to accommodate the bypass diode assembly. This way the bypass diode assembly may be accommodated within the enclosure without making the enclosure significantly larger and without blocking any part of the active surface of the solar cell assembly with the bypass diodes.

In a further embodiment according to the first aspect, the bypass diode assembly allows individual bypassing of each of the solar cell elements of the solar cell assembly. It is contemplated that in some embodiments according to the present invention the solar cell assembly may comprise a string of interconnected solar cell elements, where each element comprises a single p-n junction, e.g. series-connected for increasing the voltage of the solar cell assembly. The number of solar cell elements in each solar cell assembly is typically a small number below 20, preferably maximum 10, more preferably below 8, such as 2 or 4. However, in a particular embodiment according to the first aspect, each solar cell element may be individually bypassed. Thus, when a single solar cell element falls out, it may be individually bypassed, and the rest of the solar cell elements in the solar cell assembly will remain unaffected.

In a further embodiment according to the first aspect, the set of individual bypass diodes includes at least 2 individual bypass diodes, such as 2-5, 6-10 or 11-20, preferably 4-10, more preferably 6-8. The above numbers of bypass diodes have been found to be appropriate for achieving proper heat dissipation in most cases.

In a further embodiment according to the first aspect, the bypass diodes are separated by 1-5 mm and preferably 3 mm. A separation of about 3 mm will allow each bypass diode a sufficient surface for dissipating the generated thermal energy to the outside without any risk of overheating the enclosure or the diode itself.

In a further embodiment according to the first aspect, the bypass diode assembly is being located at the periphery of the solar cell assembly. To avoid the occurrence of hotspots, the bypass diodes should be distributed over a large area. By distributing the bypass diodes, the effective cooling is increased. By accommodating the bypass diode assembly at the periphery of the solar cell assembly, the thermal energy may be efficiently dissipated to the surroundings and the occurrence of hotspots will be avoided. The reception of solar light may be reduced near the periphery of the solar cell assembly, thus making the placement of bypass diodes at the periphery of the solar module particularly advantageous.

In a further embodiment according to the first aspect, the bypass diode assembly defines a thickness substantially equal to the thickness of the solar cell assembly. For retaining a low profile shape of the solar module, the thickness of the bypass diode must not substantially exceed the thickness of the solar wafer for preventing any bulges in the enclosure. Commercial available low-profile bypass diodes are preferably used.

In a further embodiment according to the first aspect, the thickness of the solar cell assembly is about 0.05-1 mm, preferably 0.2 mm. The standard thickness of solar modules is between 0,05 and 2 mm for allowing sufficient rigidity, and at the same time achieving a low weight of the solar module and little material use.

In a further embodiment according to the first aspect, the front and back plate of the enclosure may comprise any of the materials glass, polyester or EVA. The front and back plates of the enclosure typically comprise a material, which is transparent for allowing solar light to reach the solar wafer without any considerable absorption losses in the housing. The front plate should be transparent for allowing solar light to enter and impinge the active area of the solar cell assembly. The back plate may be transparent, opaque or reflective.

The above need and object together with numerous other needs and objects, which will be evident from the below detailed description of a preferred embodiment of the module according to the present invention, are according to a second aspect of the present invention obtained by a solar module, comprising a shallow enclosure, comprising a back plate and a corresponding front plate, the front plate being transparent to solar light, the enclosure further comprising a solar cell assembly being accommodated between the front and back plates, the solar cell assembly comprising:
a solar cell of semiconductor-based material exposed to solar light at the front plate,
a piezoelectric alarm, being powered by the solar cell or solar cell assembly and/or the energy storage unit, the piezoelectric alarm being adapted for generating a sound pressure level of at least 100dB at a distance of 1 m from the solar module, and
a control circuitry, being connected between the solar cell or solar cell assembly and the piezoelectric alarm for activating the piezoelectric alarm when the solar module has been removed from its installed location without any prior authorisation.

The piezoelectric alarm inside the solar module will deter anyone from trying to remove the solar module without authorisation. The thief would be unable to use the module when the alarm has been initiated, and the acoustic noise generated by the piezoelectric alarm will alert law enforcement officers to the location of the solar module. The sound level of at least 100dB may additionally prevent the thief from continuing the attempt of removing the solar module. The piezoelectric alarm may further be configured to deactivate the solar module when any theft attempt has been made. Since the piezoelectric alarm is integrated into the enclosure between the front plate and the back plate, any ad hoc attempt of disabling the piezoelectric alarm would be particular cumbersome and would most probably result in the solar module breaking before the alarm is turned off. In particular, the area where the piezoelectric alarm is integrated may be laminated with either a glass plate or a metal plate so that the piezoelectric alarm cannot be separately removed without breaking the solar module.

In a further embodiment according to the second aspect, the solar cell or solar cell assembly may comprise an energy storage unit, being connected to the solar cell or solar cell assembly for storing at least part of the electrical energy generated in the solar cell. Typically, an energy-storing unit is not needed, since the piezoelectric alarm may be powered directly by the solar cell or solar cell assembly. However, in some embodiments the energy storage unit may comprise a flat, rechargeable battery or the like for storing electrical energy needed to power the piezoelectric alarm. Since most thefts occur at night, powering the piezoelectric alarm directly from the solar cell will not be appropriate in all cases. The control circuitry is used for activating the piezoelectric alarm in case the solar module is removed from its installed location. The activation involves directing electrical energy from the energy storage unit to the piezoelectric alarm.

Solar modules are normally provided as an arrangement including large numbers of electrically connected modules. The piezoelectric alarm may be initiated when the control circuitry determines that the solar module is disconnected from the assembly. Alternatively, the solar module may be provided with a motion sensor. The control circuitry may require a code to be provided before allowing use of the solar module when the solar module has been removed from its original location. The code is preferably provided by entering a numeric combination on a keypad by holding a RFID tag near the solar module or by any similar authorisation method. By providing the code, the subsequent removal of the solar module is regarded as being authorised and the alarm will not be initiated.

The above need and object together with numerous other needs and objects, which will be evident from the below detailed description of a preferred embodiment of the module according to the present invention, are according to a third aspect of the present invention obtained by a solar module, comprising a shallow enclosure, comprising a back plate and a corresponding front plate, the front plate being transparent to solar light, the enclosure further comprising a solar cell assembly being accommodated between the front and back plates, the solar cell assembly comprising:
a solar cell of semiconductor-based material exposed to solar light at the front plate, and
an energy storage unit for storing at least part of the electrical energy generated in the solar cell or solar cell assembly, the energy storage unit being electrically connected to the solar cell or solar cell assembly, and when the solar module is in use, the electrical storage unit selectively assuming either a storing mode, in which electrical energy is transported from the solar cell or solar cell assembly to the electrical storage unit when the solar cell is exposed to solar light, or a delivering mode, in which electrical energy is transported from the storage unit to the solar cell or solar cell assembly for generating visual light.

An energy storing unit such as a flat, rechargeable battery or capacitor or the like may be provided for storing excessive electrical energy when the solar module is subjected to light. When the solar module is not subjected to solar light or when the energy from the incoming light is very small, the battery or capacitor may be used for delivering power back to the solar module. By providing current to the solar cells, the solar cells may be caused to emit light, which may be visible during low light conditions such as at night. Thus, the electrical storage unit described above may be used as a light-generating device at night powered by environmentally friendly solar energy collected during the day.

The electrical storage unit should be included in the enclosure between the front plate and the back plate. A common electrical storage unit may be connected to several solar cells. When the electrical storage unit assumes the storing mode, electrical power flows towards the electrical storing unit for charging the electrical storing unit. When the electrical storage unit assumes the delivering mode, the electrical energy previously collected will return to the solar cell and cause the solar cell to emit light.

In a further embodiment according to the third aspect, the electrical storage unit comprises a photo detection unit for determining whether the electrical storage unit should assume the storing mode or the delivering mode, the photo detection unit determining the storing mode to be assumed when the exposure to solar light exceeds a critical value, and the delivering mode when the exposure to solar light does not exceed the critical value. In this way the solar module will automatically start emitting light when the solar module is shaded, i.e. at night. During the daytime the solar module will collect energy as previously described.

In a further embodiment according to the third aspect, the electrical storage unit comprises a control unit, when in the delivering mode the control unit selectively allows or prevents electrical energy to be transported from the storage unit to the solar wafer for generating a specific light pattern. The pattern may be used at nighttime for artistic, commercial or similar purposes. It is contemplated that further electronic devices may be incorporated into the solar module and in particular the control unit. Such electronic devices may e.g. include a DC/AC converter for the solar module to provide AC output current. By electronic devices is meant any discrete component or circuitry as well as IC component providing a substantial amount of intelligence into the solar module.

The above need and object together with numerous other needs and objects, which will be evident from the below detailed description of a preferred embodiment of the module according to the present invention, are according to a fourth aspect of the present invention obtained by a method of manufacturing a solar module by providing:
a shallow enclosure, comprising a back plate and a corresponding front plate, the front plate being transparent for exposure to solar light,
a plurality of solar cell assemblies, comprising one or more solar cell elements of semiconductor based material, and
a plurality of bypass diode assemblies, the plurality of bypass diode assemblies being identical to the plurality of solar cell assemblies, and each specific bypass diode assembly having a corresponding solar cell assembly, the plurality of bypass diode assemblies comprising a plurality of parallel- or series-connected individual bypass diodes being separated in relation to each other for allowing residual heat generated by the individual bypass diodes to dissipate,
the method further comprising performing the following steps:
encapsulating the solar cell assemblies within the enclosure between the front plate and the back plate and exposing the solar cell elements to solar light at the front plate, and
accommodating the bypass diode assembly juxtaposed with the solar cell elements and electrically connecting the bypass diode assembly in parallel in relation to one or more solar cell elements for allowing individual bypassing of each of the solar cell assemblies.

It is evident that the above method according to the fourth aspect may be used together with any of the first, second and third aspects of the present invention.

Below follows a brief description of the drawings, in which:
Fig 1A is a first and presently preferred embodiment of a solar module,
Fig 1B is a further embodiment of a solar module,
Fig 1C is a perspective view of a solar module,
Fig 2A is a solar cell arrangement,
Fig 2B is a forward biased solar cell,
Fig 2C is a backward biased solar cell,
Fig 3A-B is a piezoelectric alarm module,
Fig 4A-B is a solar assembly of solar modules during the daytime and a close-up, respectively, and
Fig 4C-D is a solar assembly of solar modules at nighttime and a close-up, respectively.

Below follows a detailed description of a preferred embodiment according to the present invention:

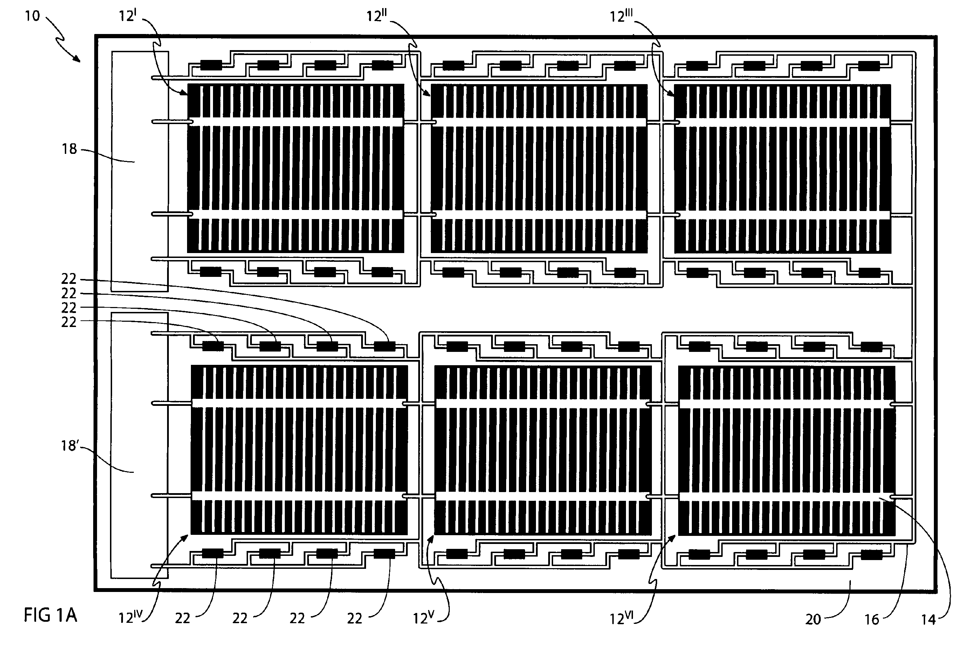

Fig 1A shows a top view of a solar module 10, comprising six solar cell elements 12. The solar cell elements 12 constitute a thin plate made of mono-crystalline or polycrystalline silicon, which has been doped with a doping material to form a p-n junction. A separate conductor grid 14 is applied to the upward and downward surface of the solar cell element 12, respectively. Conductor strips 16 connect the six solar cell elements 12 in a series connection so that the downwardly facing conductor grid (not visible) of the first solar cell element 12^{I} is connected to the upwardly facing conductor grid 14 of the subsequent solar cell element 12". The other solar cell elements 12^{II}-12^{VI} are connected likewise. The first solar cell element 12^{I} and the sixth solar cell 12^{VI} are connected to a plus terminal 18 and a minus terminal 18'. The conductor grids 14 and conductor strips 16 constitute thin metal strips. By connecting the solar cell elements 12 in series as shown in Fig 1A, a higher voltage is generated between the terminals 18, 18' than would be generated by a single cell 12 or a plurality of parallel-connected solar cell elements 12. Each cell typically generates a maximum voltage of about 0.5V. Thus, the solar module 10 will generate a maximum voltage of about 3V. Several solar modules 10 may be connected in series for even higher voltage output. The solar cell elements 12 and conductor strips 16 are accommodated on a back plate 20. The back plate is either made of glass, polyester, EVA or a similar material. The back plate 20 may be coated with a reflective layer to reflect any incoming radiation back to the solar cell elements 12. The back plate 20 should be made rigid for protecting the fragile solar cell elements 12.

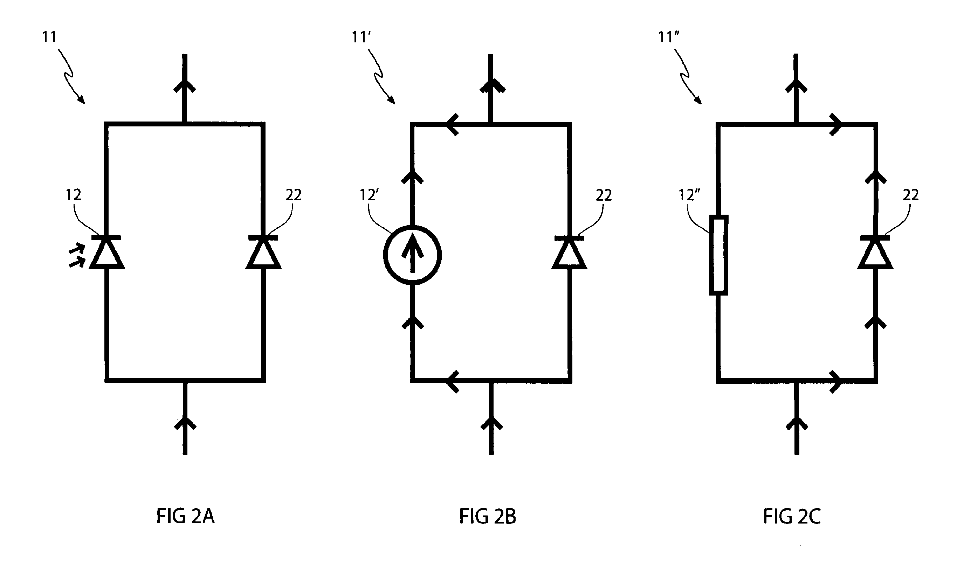

The solar cells must not overlap and a sufficient space must be provided on each side of the solar cell elements 12 for avoiding short-circuit with nearby solar cells. The space may be used for accommodating bypass diodes. Each of the solar cell elements 12 has eight parallel-connected small bypass diodes 22, which are distributed on each side of the solar cell and form a bypass diode assembly effectively acting as a single large bypass diode, however, distributing the heat generated by the bypass diodes 22 over a larger surface and allowing the individual bypass diodes 22 to be smaller. The bypass diodes 22 protect the solar cell in case of malfunction or shading. The function of the bypass diodes 22 will be described in detail later in connection with Fig 2. By distributing the bypass diodes 22, the thermal energy generated in each bypass diode will be distributed for avoiding overheating and hotspots, which may permanently damage the solar module 10. A plurality of bypass diodes also provides redundancy in case of a failure in one of the bypass diodes. It is further contemplated that additional bypass diodes may be connected in parallel in relation to the solar cell element 12 for additional thermal distribution and redundancy.

The above configuration allows individual bypassing of a faulty solar cell element 12. Thus, the voltage loss due to a malfunctioning solar cell element 12 will be limited to the single cell element and the rest of the solar module 10 will continue to work as intended. This feature is particularly important when using silicon material of a lesser quality than solar grade, such as metallurgical grade. The failure rate of metallurgical grade silicon exceeds by far the failure rate of solar grade silicon. However, taking into account its significantly lower price, for some commercial applications it may be contemplated to use metallurgical grade silicon instead of solar grade silicon, as long as the failure of a single cell is restricted to a loss of voltage corresponding to the single cell, and the other functioning cells remain unaffected. The bypass diodes 22 are connected by using conductor strips of the same type as used for connecting the solar cell elements 12, and designated the reference numeral 16. It is contemplated that for some applications it may be desired to use a plurality of bypass diodes 22 connected in series with a set of solar cell elements 12, such as 2, 4, 8, 16 or 32 solar cell elements 12.

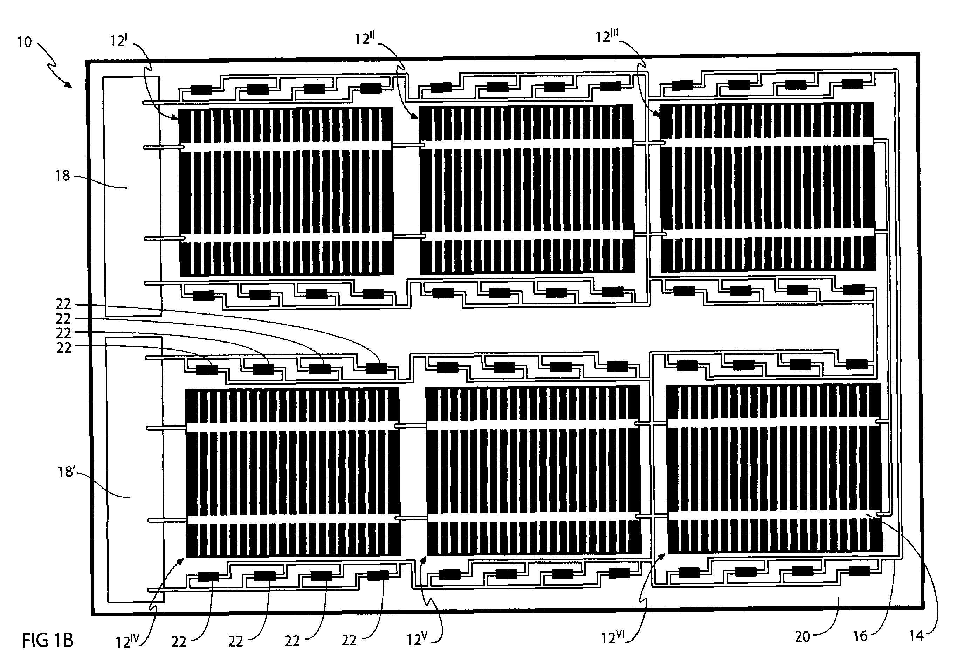

Fig 1B shows a top view of a solar module 10 as shown in Fig 1A, however, some of the individual solar cell elements 12 are series-connected, i.e. the solar cell elements 12 having the indexation I-II, III-IV and V-VI, respectively. Such configuration, where several of the solar cell elements 12 are connected to form a solar cell assembly, is typically referred to as a solar cell string. By series-connecting a number of solar cell elements 12, a solar cell having a higher voltage may be achieved. It should, however, be noted that a breakdown or malfunction of a solar cell element 12 typically renders the whole solar cell string or assembly inoperable, thus, the number of solar cell elements 12 in each string should be low.

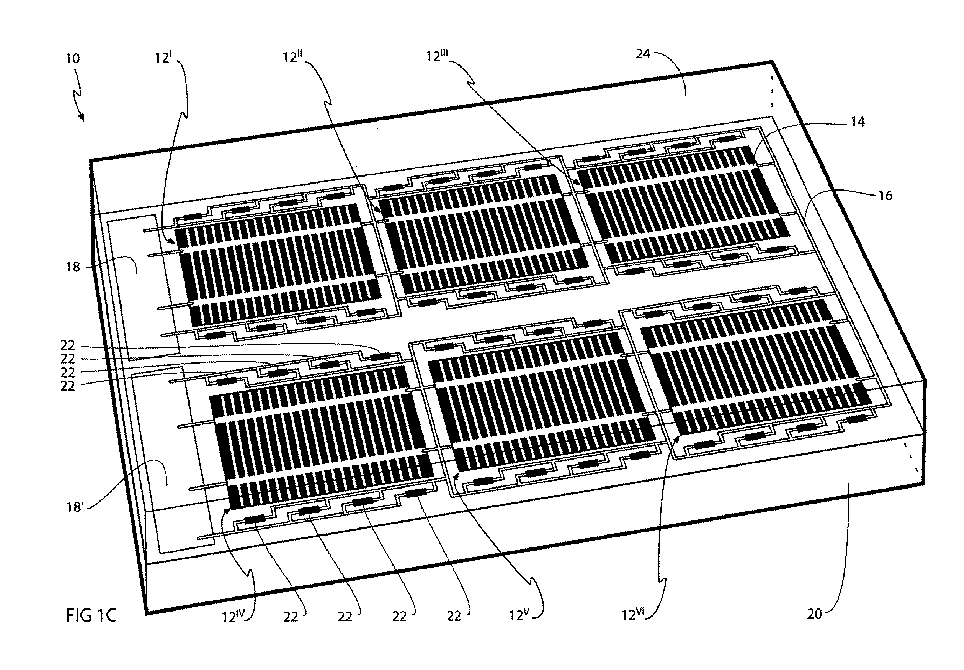

Fig 1C shows a perspective view of the solar module 10 as shown in Fig 1A. The solar cell elements 12 are accommodated between a back plate 20 and a front plate 24. The front plate is made of a light-permeable material, preferably glass, polyester or EVA or any similar material having some heat-conductive properties for transporting residual heat from the bypass diodes 22 to the outside. The bypass diodes 22 are low-profile diodes having a thickness corresponding to the thickness of a solar cell element 12. The thickness is typically less than 1 mm, such as 0.2mm. In this way the solar cell element 12 and the bypass diode 22 form an even surface, which simplifies the application of the front plate 24 and gives the solar cell a more attractive exterior. The bypass diode 22 may preferably be located near the outer periphery of the back plate 20. Typically, a space of 1-3mm is provided between the solar cell element 12 and the outer periphery of the back plate 20. By placing the bypass diodes 22 near the outer periphery of the back plate 20, residual heat may be conducted more efficiently to the outside of the solar module 10. Moreover, the periphery of the solar module is typically shaded from solar light since it is used for accommodating a framing or similar structure for keeping the solar module assembled and for mounting purposes. It is contemplated that for large solar modules 10 the spacing between solar cells may as well be used for bypass diodes 22, as illustrated in the present embodiment.

Fig 2 shows the two different operational modes of the solar cell, the power generation mode and the bypassing mode.

Fig 2A shows a solar module 10' comprising a solar cell element 12 being connected in series with a bypass diode 22.

Fig 2B shows the solar module 10" of Fig 2A in the power generation mode. In the power generation mode the solar cell is forward biased and the bypass diode is negatively biased. In the power generation mode, the solar cell 22' constitutes a voltage source driving a current and generating power. The generating mode is automatically assumed when solar radiation irradiates a functional solar cell and causes a voltage between the poles of the solar cell. The current flows through the solar cell as shown and the bypass diode will become negatively biased and, thus, will not conduct any current.

Fig 2C shows the solar module 10"' of Fig 2A in the bypassed mode. In the bypassed mode, the solar cell is forward biased and the bypass diode is negatively biased. In the bypassed mode, the solar cell 22" constitutes an electrical resistance, and, thus, the current will take the alternative path through the bypass diode. The bypassed mode will be automatically assumed when the solar cell is shaded, i.e. not irradiated by radiation. The bypassed mode is also assumed when the solar cell is malfunctioning. The solar cell may malfunction due to wear, however, most commonly due to impurities within the silicon. Such malfunctions are much more likely when using metallurgic silicon. However, the lower price of metallurgic silicon may make it economically attractive to use, however, always in combination with bypass diodes. The bypass diode then assumes positive biasing and will become conductive for allowing the current to bypass the solar cell, thereby avoiding any overheating of the solar cell, which may lead to power loss as well as malfunction of the whole solar module.

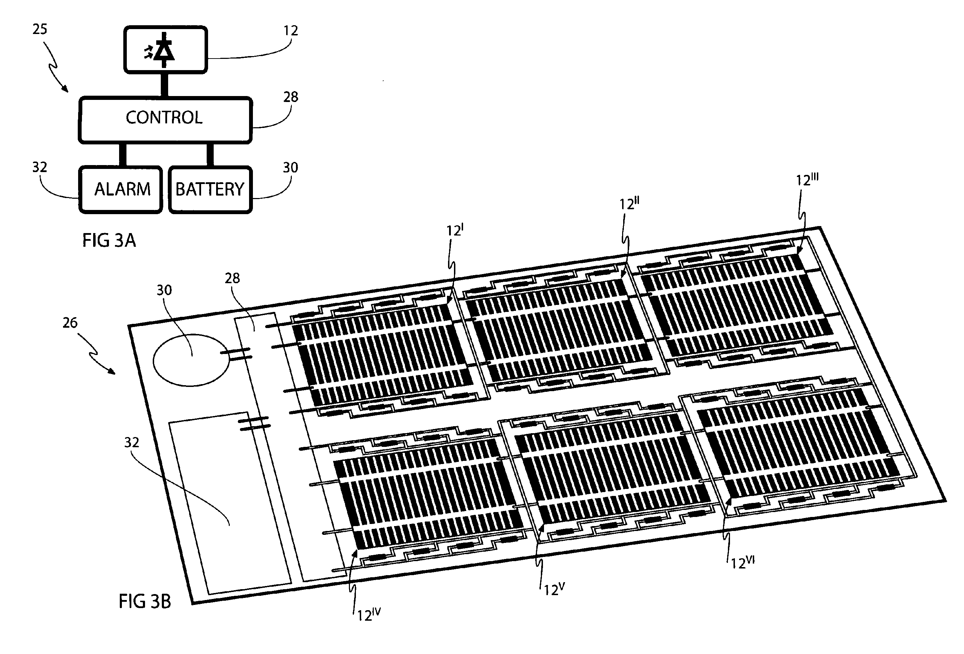

Fig 3A shows a flow chart diagram 25 of a safety module 26, including a piezoelectric alarm system 32. The safety module includes at least one solar cell element 12, being connected to a control board 28. The control board 28 is further connected to a flat, rechargeable battery 30, which is charged during the daytime and provides energy at nighttime. The control board 28 is further connected to the piezoelectric alarm system 32. The piezoelectric alarm system may include a piezoelectric crystal and a resonance circuit of about 400-4000Hz for achieving an audible acoustic signal of at least 100dB at a distance of 1 m from the alarm. The control board 28 may include a motion detector, which triggers the alarm. Alternatively, connection may be provided with a neighbouring module for enumerating neighbours, such that when one module is removed, the alarm of all of the adjacent modules is triggered as well. The control unit should provide means for shutting down the alarm system, such as the ability to provide a code, either by an external computer or keyboard being connected to the safety module via cable, or remotely via an RDIF tag.

Fig 3B shows a perspective view of the safety module 26. The control board 28, the battery 30 and the piezoelectric alarm 32 are all laminated between the front and back plates and accommodated beside the solar cell elements 12. Thereby, an unauthorised person will have to break the module to be able to turn off the alarm.

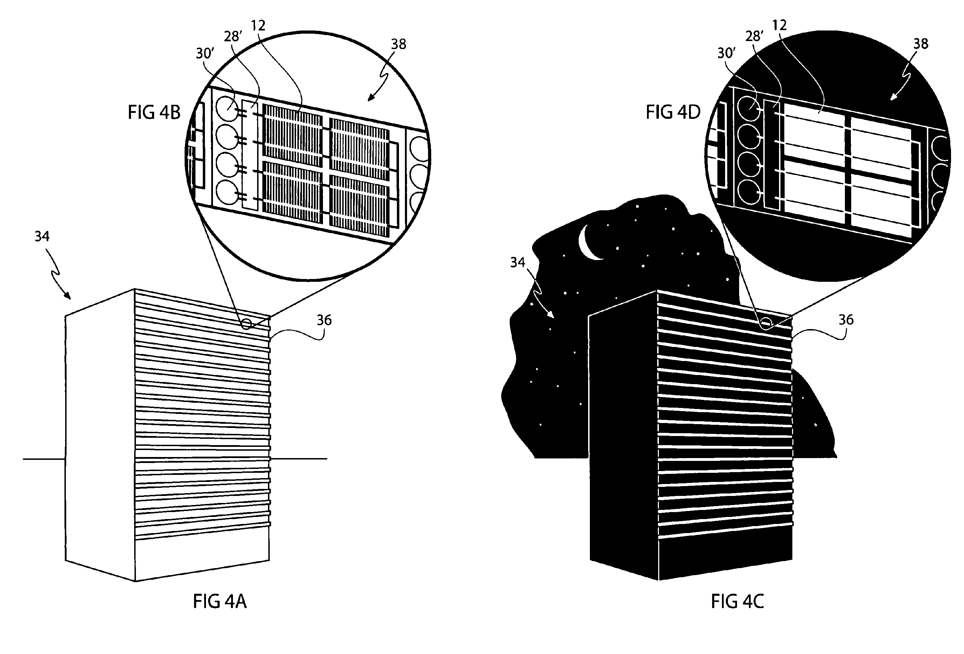

Fig 4A shows a solar array 36, comprising a set of self-illuminating solar modules 38 mounted on the facade of a building 34 during the daytime. The self-illuminating solar modules 38 will be described later in connection with Fig 4B. During the daytime, the self-illuminating solar modules 38 provide shading to the building while collecting solar light and storing the generated electrical energy. The self-illuminating solar modules 38 may be configured as solar shades, which may be pivoted for preventing excessive solar light from entering the windows of e.g. an office building. Alternatively, the windows themselves may be provided with solar cells or constitute solar cells.

Fig 4B shows a close-up view of the solar array of Fig 4A. The solar module 38 comprises a plurality of solar cell elements 12 connected to a control board 28', which charges one or more rechargeable batteries 30'. The control board 28' may assume a charging mode and a discharging mode. The control board 28' comprises a circuit board having the same thickness as the solar cell. During the daytime, the control board assumes the charging mode, thus, electrical energy is flowing from the solar cells to the batteries.

Fig 4C shows the solar array 36 of Fig 4A at nighttime. The energy, which has been stored in the batteries during the daytime, may be sent back to the solar cells at night for achieving a visual effect. The solar array will, thus, glow, giving a pleasant illumination of the building 34 and the near surroundings. The solar array 36 may, thus, be used as a facade illumination for exposing the building 34 at night and improve the appearance of the neighbourhood. Further, the solar array may be used to illuminate the sidewalk or even as a replacement for street lamps. The solar array 36 may also be configured to generate a specific pattern for artistic purposes. Alternatively, commercial messages may be delivered via the solar array 36.

Fig 4D shows a close-up view of the solar array of Fig 4C. The solar cell elements 12 are illuminated by drawing electrical energy from the batteries 30' to the solar cell elements 12 via the control board 28'. The energy stored in the batteries 30' has been collected from solar radiation during the daytime. Thus, the present embodiment provides an environmentally friendly alternative to externally powered light sources for illuminating buildings. At nighttime the control board 28' assumes discharging mode.

The control board 28' may be configured to change from charging mode to discharging mode at a specific time, or preferably the control board 28' is equipped with a light sensor, changing from charging mode to discharging mode when the light intensity falls below a certain level. Yet alternatively, a voltage sensor may be used for changing from charging mode to discharging mode when the output voltage of the solar cells falls below a certain level. The control board 28' may further provide a protection circuit for eliminating the risk of overstressing the solar cells during charging and discharging.

### List of parts

- 10.: Solar module
- 12.: Solar cell element
- 14.: Conductor grid
- 16.: Conductor strips
- 18.: Terminal
- 20.: Back plate
- 22.: Bypass diode
- 24.: Front plate
- 25.: Flow chart diagram
- 26.: Safety module
- 28.: Control board
- 30.: Rechargeable battery (flat)
- 32.: Piezoelectric alarm system
- 34.: Building facade
- 36.: Solar array
- 38.: Self-illuminating solar module

## Claims

1. A solar module, comprising a shallow enclosure, comprising a back plate and a corresponding front plate, said front plate being transparent to solar light, said enclosure further comprising a plurality of solar cell assemblies and a plurality of bypass diode assemblies, all being accommodated between said front and back plates, said plurality of bypass diode assemblies being identical to said plurality of solar cell assemblies and each specific bypass diode assembly having a corresponding solar cell assembly, each of said solar cell assemblies comprising:
one or more solar cell elements of semiconductor based material exposed to solar light at said front plate, and
each of said bypass diode assemblies comprising:
a set of parallel- and/or series-connected individual bypass diodes, being separated in relation to each other for allowing residual heat generated by said individual bypass diodes to dissipate, said individual bypass diodes being accommodated juxtaposed with said one or more solar cell elements and electrically connected in parallel in relation to said one or more solar cell elements for allowing individual bypassing of each of said solar cell assemblies of said plurality of solar cell assemblies.

2. The solar module according to claim 1, wherein said bypass diode assembly allows individual bypassing of each of said solar cell elements of said solar cell assembly.

3. The solar module according to any of the preceding claims, wherein said set of individual bypass diodes includes at least 2 individual bypass diodes, such as 2-5, 6-10 or 11-20, preferably 4-10, more preferably 6-8.

4. The solar module according to any of the preceding claims, wherein said bypass diodes are separated by 1-5 mm and preferably by 3 mm.

5. The solar module according to any of the preceding claims, wherein said individual bypass diodes are being located at the periphery of said solar cell assembly.

6. The solar module according to any of the preceding claims, wherein said individual bypass diodes define a thickness substantially equal to said thickness of said solar cell assembly.

7. The solar module according to claim 6, wherein said thickness of said solar cell assembly is about 0.05-1 mm, preferably 0.2 mm.

8. The solar module according to any of the preceding claims, wherein said front and back plate of the enclosure may comprise any of the materials glass, polyester or EVA.

9. A solar module, comprising a shallow enclosure, comprising a back plate and a corresponding front plate, said front plate being transparent to solar light, said enclosure further comprising a solar cell assembly being accommodated between said front and back plates, said solar cell assembly comprising:
a solar cell of semiconductor-based material exposed to solar light at said front plate,
a piezoelectric alarm, being powered by said solar cell or solar cell assembly and/or said energy storage unit, said piezoelectric alarm being adapted for generating a sound pressure level of at least 100dB at a distance of 1 m from said solar module, and
a control circuitry, being connected between said solar cell or solar cell assembly and said piezoelectric alarm for activating said piezoelectric alarm when said solar module has been removed from its installed location without any prior authorisation.

10. The solar module according to claim 9, wherein said solar cell or solar cell assembly comprises an energy storage unit being connected to said solar cell or solar cell assembly for storing at least part of the electrical energy generated in said solar cell or solar cell assembly.

11. A solar module, comprising a shallow enclosure, comprising a back plate and a corresponding front plate, said front plate being transparent to solar light, said enclosure further comprising a solar cell assembly being accommodated between said front and back plates, said solar cell or solar cell assembly comprising:
a solar cell of semiconductor-based material exposed to solar light at said front plate, and
an energy storage unit for storing at least part of the electrical energy generated in said solar cell or solar cell assembly, said energy storage unit being electrically connected to said solar cell or solar cell assembly, and when said solar module is in use, said electrical storage unit selectively assuming either a storing mode, in which electrical energy is transported from said solar cell or solar cell assembly to said electrical storage unit when said solar cell or solar cell assembly is exposed to solar light or a delivering mode, in which electrical energy is transported from said storage unit to said solar cell or solar cell assembly for generating visual light.

12. The solar module according to claim 9, wherein said electrical storage unit comprises a photo detection unit for determining whether said electrical storage unit should assume said storing mode or said delivering mode, said photo detection unit determining said storing mode to be assumed when the exposure to solar light exceeds a critical value, and said delivering mode when the exposure to solar light does not exceed said critical value.

13. The solar module according to any of the claims 11-12, wherein said electrical storage unit comprises a control unit, and when in said delivering mode, said control unit selectively allows or prevents electrical energy being transported from said storage unit to said solar wafer for generating a specific light pattern.

14. A method of manufacturing a solar module by providing:
a shallow enclosure, comprising a back plate and a corresponding front plate, said front plate being transparent for exposure to solar light,
a plurality of solar cell assemblies, comprising one or more solar cell elements of semiconductor based material, and
a plurality of bypass diode assemblies, said plurality of bypass diode assemblies being identical to said plurality of solar cell assemblies and each specific bypass diode assembly having a corresponding solar cell assembly, said plurality of bypass diode assemblies comprising a plurality of parallel- or series-connected individual bypass diodes being separated in relation to each other for allowing residual heat generated by said individual bypass diodes to dissipate,
said method further comprising performing the following steps:
encapsulating said solar cell assemblies within said enclosure between said front plate and said back plate and exposing said solar cell elements to solar light at said front plate, and
accommodating said bypass diode assembly in a juxtaposed position in relation to said solar cell elements and electrically connecting said bypass diode assembly in parallel in relation to said one or more solar cell elements for allowing individual bypassing of each of said solar cell assemblies.

15. The method according to claim 14, further comprising any of the features of claims 1-14.
